# EUROPEAN PATENT SPECIFICATION

(11) **EP 3 909 071 B1**
(45) Date of publication and mention of the grant of the patent: **04.11.2026**
(21) Application number: 20738967.7
(22) Date of filing: 08.01.2020
(51) Int. Cl.: H10W 72/20, H10P 72/30, H10W 72/00, H10W 90/00

(54) **METHODS OF BONDING OF SEMICONDUCTOR ELEMENTS TO SUBSTRATES, AND RELATED BONDING SYSTEMS**
VERFAHREN ZUM VERBINDEN VON HALBLEITERELEMENTEN MIT SUBSTRATEN UND ZUGEHÖRIGE VERBINDUNGSSYSTEME
PROCÉDÉS DE LIAISON D'ÉLÉMENTS SEMI-CONDUCTEURS À DES SUBSTRATS ET SYSTÈMES DE LIAISON ASSOCIÉS

(30) Priority: 09.01.2019 US 201962790259 P; 28.09.2019 US 201962907562 P
(43) Date of publication of application: 17.11.2021
(60) Divisional application: 22020106.5 / 4 057 332; 22020107.3; 22020125.5 / 4 057 333
(73) Proprietor: Kulicke and Soffa Industries, Inc., Fort Washington, PA 19034 (US)
(72) Inventor: BAJWA, Adeel Ahmad, Blue Bell, PA 19422 (US); COLOSIMO, Thomas J., Chester, PA 19380 (US)
(74) Representative: Körner, Thomas Ottmar
(86) International application number: PCT/US2020/012690
(87) International publication number: WO 2020/146466

(56) References cited:
- JP-A- 2000 349 102
- JP-A- 2013 251 404
- KR-A- 20130 083 400
- US-A1- 2002 130 164
- US-A1- 2009 142 903
- US-A1- 2011 045 653
- US-A1- 2011 198 388
- US-A1- 2015 001 282
- US-A1- 2015 048 523

## Description

### FIELD

The invention relates to bonding systems and methods (such as flip chip, thermocompression, and thermosonic bonding systems and processes), and more particularly, to improved systems and methods for bonding a semiconductor element to a substrate.

### BACKGROUND

Traditional semiconductor packaging typically involves die attach processes and wire bonding processes. Advanced semiconductor packaging technologies (e.g., flip chip bonding, thermocompression bonding, etc.) continue to gain traction in the industry. For example, in thermocompression bonding (i.e., TCB), heat and/or pressure (and sometimes ultrasonic energy) are used to form a plurality of interconnections between (i) electrically conductive structures on a semiconductor element and (ii) electrically conductive structures on a substrate.

US 2009/142903 A1 describes an exemplary bonding apparatus, in particular for performing a die bonding process, according to the pre-characterizing part of claim 1, said apparatus including a cleaning module designed for cleaning chips; and a chip-to-wafer bonding chamber configured to receive the chips from the cleaning module and designed for bonding the chips to a wafer.

Each of US2011/198388 A1 and US2015/001282 A1 also discloses a bonding apparatus.

In certain flip chip bonding or thermocompression bonding applications, the electrically conductive structures of the semiconductor element and/or the substrate may include copper structures (e.g., copper pillars) or other material(s) that is subject to oxidation and/or other contamination. In such applications, it is desirable to provide an environment suitable for bonding. Conventionally, such an environment may be provided by using a reducing gas at the bonding area to reduce potential oxidation and/or contamination of the electrically conductive structures of the semiconductor element or the substrate to which it will be bonded.

Thus, it would be desirable to provide improved methods of bonding semiconductor elements to a substrate with the use of a reducing gas.

### SUMMARY

A bonding system for bonding a semiconductor element to a substrate in accordance with the invention as hereinafter claimed comprises the features of claim 1 below.

A method of bonding a semiconductor element to a substrate in accordance with the invention as hereinafter claimed comprises the features of claim 9 below.

### BRIEF DESCRIPTION OF THE DRAWINGS

The invention is best understood from the following detailed description when read in connection with the accompanying drawings. It is emphasized that, according to common practice, the various features of the drawings are not to scale. On the contrary, the dimensions of the various features are arbitrarily expanded or reduced for clarity.
FIG. 1A is a block diagram illustration of a bonding system for bonding a semiconductor element to a substrate in accordance with an exemplary embodiment of the invention;
FIG. 1B is a block diagram illustration of a bonding system for bonding a semiconductor element to a substrate in accordance with an exemplary embodiment of the invention;
FIGS. 2A-2G are a series of block diagram illustrations of the bonding system of FIG. 1A, illustrating a method of bonding a semiconductor element to a substrate in accordance with an exemplary embodiment of the invention;
FIGS. 3A-3B are a series of block diagram illustrations of the bonding system of FIG. 1A, illustrating a method of bonding a semiconductor element to a substrate in accordance with an exemplary embodiment of the invention, while preparing another substrate for bonding;
FIG. 4 is a block diagram illustration of a bonding system for bonding a semiconductor element, having conductive structures including a solder material, to a substrate in accordance with an an example that is useful for understanding the present invention;
FIG. 5 is a block diagram illustration of a bonding system for bonding a semiconductor element to a substrate, having conductive structures including a solder material, in accordance with a further example that is useful for understanding the invention;
FIG. 6 is a block diagram illustration of a bonding system for bonding a semiconductor element, having conductive structures including a solder material, to a substrate, having conductive structures including a solder material, in accordance with a further example that is useful for understanding the invention;
FIG. 7 is a block diagram illustration of a bonding system for bonding a semiconductor element, having conductive structures formed of a solder material, to a substrate in accordance with a further example that is useful for understanding the invention;
FIG. 8 is a block diagram illustration of a bonding system for bonding a semiconductor element to a substrate, having conductive structures formed of a solder material, in accordance with a further example that is useful for understanding the invention;
FIG. 9 is a block diagram illustration of a bonding system for bonding a semiconductor element, having conductive structures formed of a solder material, to a substrate, having conductive structures formed of a solder material, in accordance with a further example that is useful for understanding the invention;
FIGS. 10A-10D are a series of block diagram illustrations of the bonding system of FIG. 4, illustrating a method of bonding a semiconductor element to a substrate in accordance with a further example that is useful for understanding the invention; and
FIGS. 11A-11D are a series of block diagram illustrations of another bonding system, illustrating a method of bonding a semiconductor element to a substrate in accordance with a further example that is useful for understanding the invention.

### DETAILED DESCRIPTION

As used herein, the term "semiconductor element" is intended to refer to any structure including (or configured to include at a later step) a semiconductor chip or die. Exemplary semiconductor elements include a bare semiconductor die, a semiconductor die on a substrate (e.g., a leadframe, a PCB, a carrier, a semiconductor chip, a semiconductor wafer, a BGA substrate, a semiconductor element, etc.), a packaged semiconductor device, a flip chip semiconductor device, a die embedded in a substrate, a stack of semiconductor die, amongst others. Further, the semiconductor element may include an element configured to be bonded or otherwise included in a semiconductor package (e.g., a spacer to be bonded in a stacked die configuration, a substrate, etc.).

As used herein, the term "substrate" is intended to refer to any structure to which a semiconductor element may be bonded. Exemplary substrates include, for example, a leadframe, a PCB, a carrier, a module, a semiconductor chip, a semiconductor wafer, a BGA substrate, another semiconductor element, etc.

In accordance with certain exemplary embodiments of the invention, a fluxless bonding system is provided using reducing gas/gases. The bonding system may be, for example, a flip chip bonding system, a thermocompression bonding system, a thermosonic bonding system, etc.

Aspects of the invention relate to a novel fluxless chip-to-substrate or chip-to-wafer system that avoids oxidation of metal and solder pads during bonding (e.g., during thermocompression bonding).

Exemplary systems include a "substrate oxide reduction chamber" (also referred to as a substrate cleaning compartment), a "substrate oxide prevention chamber" (also referred to as a substrate protection compartment), and a "reducing gas delivery system" (e.g., a localized chip and substrate oxide reduction bond head shroud, or other reducing gas delivery system) to eliminate the use of a fluxing process.

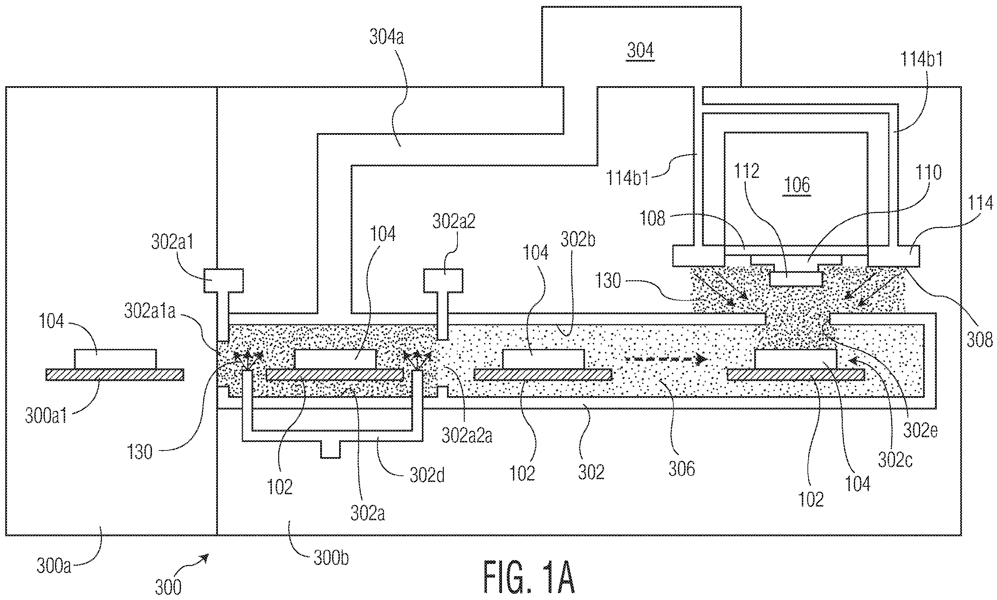

FIG. 1A illustrates exemplary bonding system 300. Bonding system 300 includes: a substrate source 300a (e.g., a wafer handler or other source) for providing a substrate(s) 104 (such as a wafer, a printed circuit board, etc.) on a support structure 300a1; and a processing system 300b. Substrate 104 is configured to be transferred to processing system 300b (e.g., including a tunnel 302, but may be a different type of structure). Tunnel 302 (or other structure, as desired) includes a substrate oxide reduction chamber 302a, a substrate oxide prevention chamber 302b, and a bonding location 302c (which is part of substrate oxide prevention chamber 302b). A reducing gas delivery system 308 is also included in processing system 300b.

In the example shown in FIG. 1A, because tunnel 302 includes both substrate oxide reduction chamber 302a and a substrate oxide prevention chamber 302b, at least a portion of substrate oxide reduction chamber 302a has a common boundary with substrate oxide prevention chamber 302b. Substrate oxide reduction chamber 302a is closed using entry door 302a1 (which closes opening 302a1a) and exit door 302a2 (which closes opening 302a2a). Another reducing gas delivery system 302d (which may be interconnected with reducing gas delivery system 308 to use a common source of reducing gas) is provided to provide a reducing gas (e.g., formic acid vapor) in substrate oxide reduction chamber 302a. After processing (e.g., removal of oxides from conductive structures of substrate 104) in substrate oxide reduction chamber 302a, a substrate transfer system (which may be part of a material handling system including support structure 102) is used to transfer substrate 104 through exit door 302a2 to substrate oxide prevention chamber 302b. Substrate oxide prevention chamber 302b includes an inert environment 306 (e.g., through a nitrogen supply, not shown for simplicity). A material handling system (e.g., including support structure 102) is used to move substrate 104 within substrate oxide prevention chamber 302b to a bonding location 302c. While at bonding location 302c, a reducing gas 130 is provided by reducing gas delivery system 308.

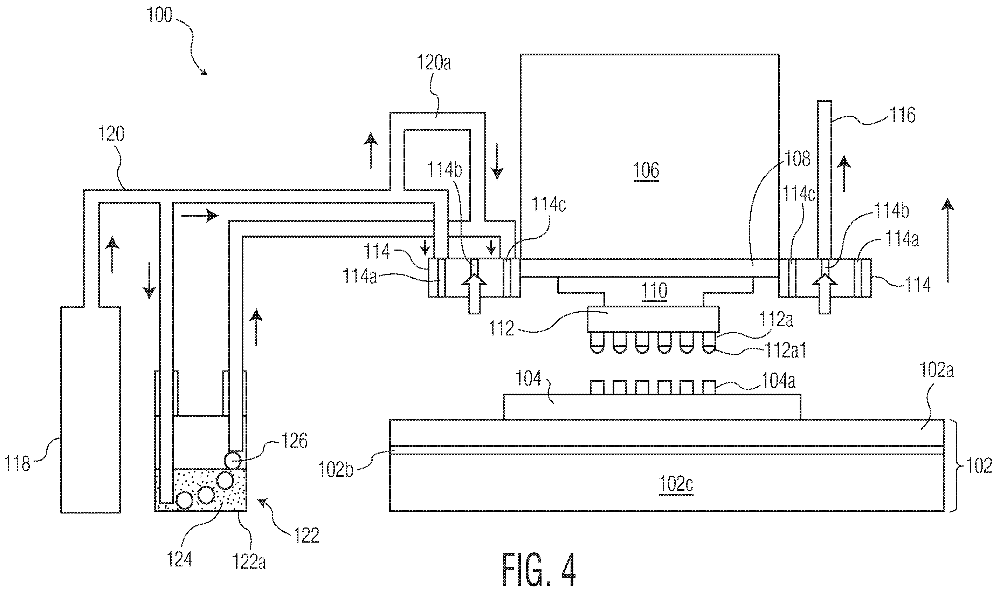

FIG. 1A also illustrates bond head assembly 106, including heater 108, and bonding tool 110. FIG. 1A also illustrates main exhaust 304 which pulls exhaust gases (e.g., gases such as reducing gas vapors) through piping 304a and 114b1 (where piping 114b1 is coupled, directly or indirectly, to center channel 114b described below). Bond head assembly 106 carries a bond head manifold 114 for receiving and distributing fluids (e.g., gases, vapors, etc.) as desired in the given application. Details of an exemplary bond head assembly 106, including exemplary bond head manifold 114, are described below in connection with FIGS. 4-9, and FIGS. 10A-10D.

In connection with a bonding operation, semiconductor element 112 is bonded to substrate 104 using bonding tool 110. During the bonding operation, corresponding ones of electrically conductive structures of semiconductor element 112 are bonded (e.g., using heat, force, ultrasonic energy, etc.) to respective ones of electrically conductive structures of substrate 104. Bond head manifold 114 provides a reducing gas 130 (e.g., where the reducing gas is a saturated vapor gas) in the area of semiconductor element 112 and substrate 104 in connection with a bonding operation. After reducing gas 130 is distributed in the area of semiconductor element 112 and substrate 104, reducing gas 130 contacts surfaces of each of electrically conductive structures of semiconductor element 112 and substrate 104.

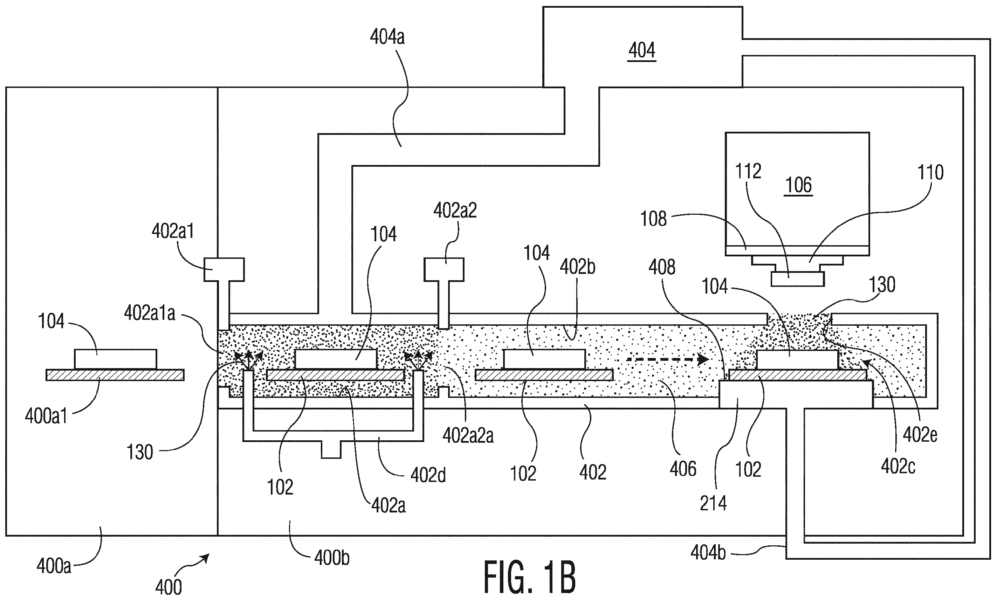

FIG. 1B illustrates exemplary bonding system 400, which is similar in many respect to bonding system 300 of FIG. 1A (where like elements have the same reference numerals, or a numberal beginning with a "4" instead of a "3"). Bonding system 400 includes a substrate source 400a (e.g., a wafer handler or other source) for providing a substrate(s) 104 (such as a wafer, a printed circuit board, etc.) on a support structure 400a1. Substrate 104 is configured to be transferred to processing system 400b (e.g., including a tunnel 402, but may be a different type of structure). Tunnel 402 (or other structure, as desired) includes a substrate oxide reduction chamber 402a, a substrate oxide prevention chamber 402b, and a bonding location 402c (which is part of substrate oxide prevention chamber 402b).

In the example shown in FIG. 1B, because tunnel 402 includes both substrate oxide reduction chamber 402a and a substrate oxide prevention chamber402b, at least a portion of substrate oxide reduction chamber 402a has a common boundary with substrate oxide prevention chamber 402b. A reducing gas delivery system 408 is also included in processing system 400b. Substrate oxide reduction chamber 402a is closed using entry door 402a1 (which closes opening 402a1a) and exit door 402a2 (which closes opening 402a2a). Another reducing gas delivery system 402d (which may be interconnected with reducing gas delivery system 408 to use a common source of reducing gas) is provided to provide a reducing gas (e.g., formic acid vapor) in substrate oxide reduction chamber 402a. After processing (e.g., removal of oxides from conductive structures of substrate 104) in substrate oxide reduction chamber 402a, a substrate transfer system (which may be part of a material handling system including support structure 102) is used to transfer substrate 104 through opening 402a2a to substrate oxide prevention chamber 402b. Substrate oxide prevention chamber 402b includes an inert environment 406 (e.g., through a nitrogen supply, not shown for simplicity). A material handling system (e.g., including support structure 102) is used to move substrate 104 within substrate oxide prevention chamber 402b to a bonding location 402c. While at bonding location 402c, a reducing gas 130 is provided by reducing gas delivery system 408.

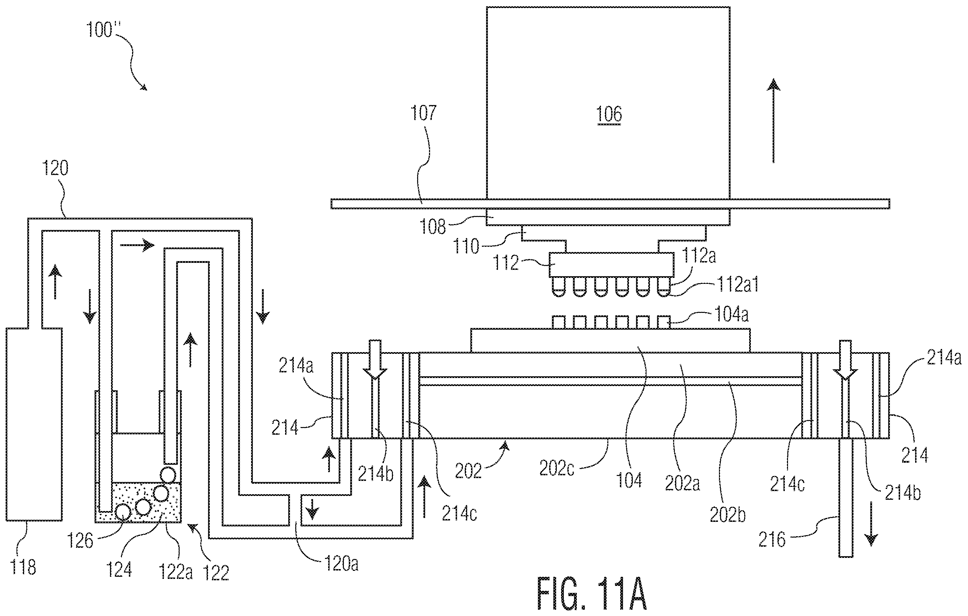

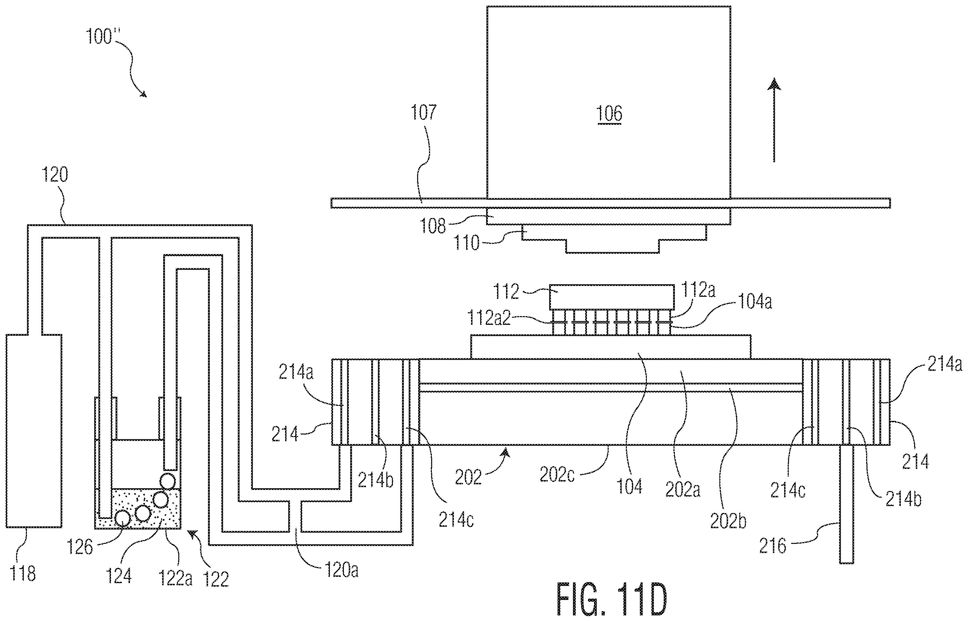

FIG. 1B also illustrates bond head assembly 106, including heater 108, and bonding tool 110. FIG. 1B also illustrates main exhaust 404 which pulls exhaust gases (e.g., gases such as reducing gas vapors) through piping 404a and 404b. A manifold 214 is provided for receiving and distributing fluids (e.g., gases, vapors, etc.) as desired in the given application. Details of an exemplary bond head assembly 106, and an exemplary manifold 214, are described below in connection with FIGS. 11A-11D).

In connection with a bonding operation, semiconductor element 112 is bonded to substrate 104 using bonding tool 110. During the bonding operation, corresponding ones of electrically conductive structures of semiconductor element 112 are bonded (e.g., using heat, force, ultrasonic energy, etc.) to respective ones of electrically conductive structures of substrate 104. Manifold 214 provides a reducing gas 130 (e.g., where the reducing gas is a saturated vapor gas) in the area of semiconductor element 112 and substrate 104 in connection with a bonding operation. After reducing gas 130 is distributed in the area of semiconductor element 112 and substrate 104, reducing gas 130 contacts surfaces of each of electrically conductive structures of semiconductor element 112 and substrate 104.

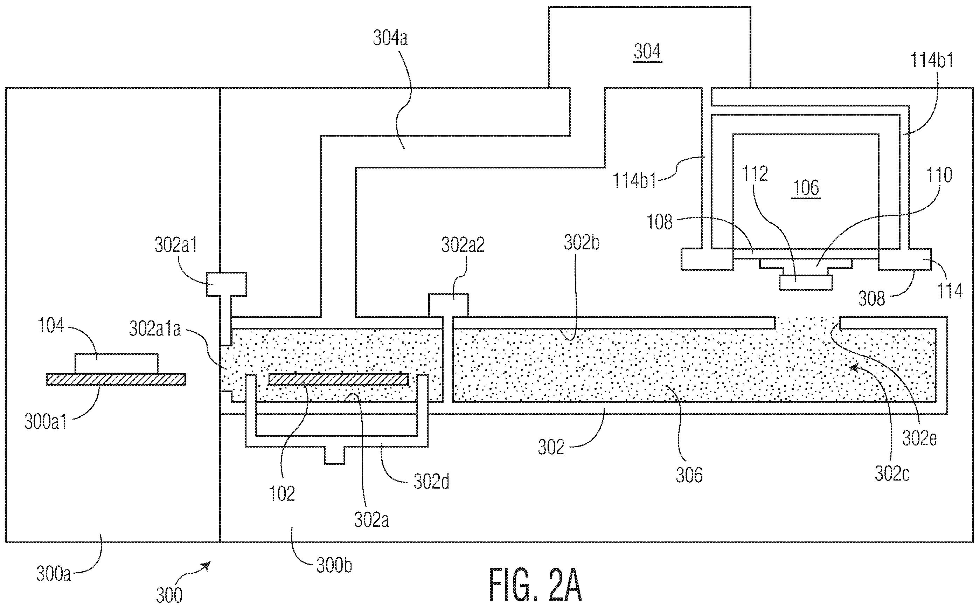

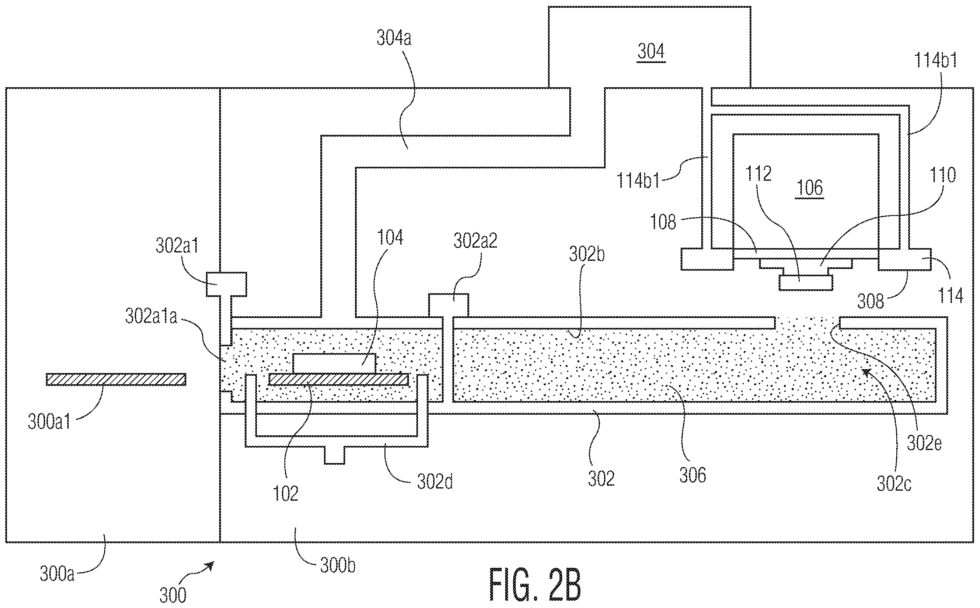

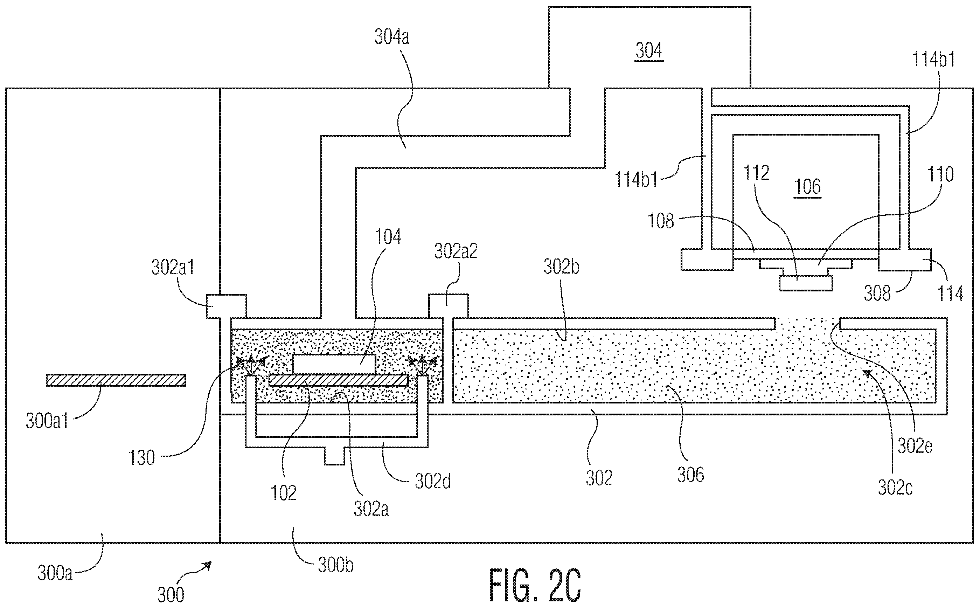

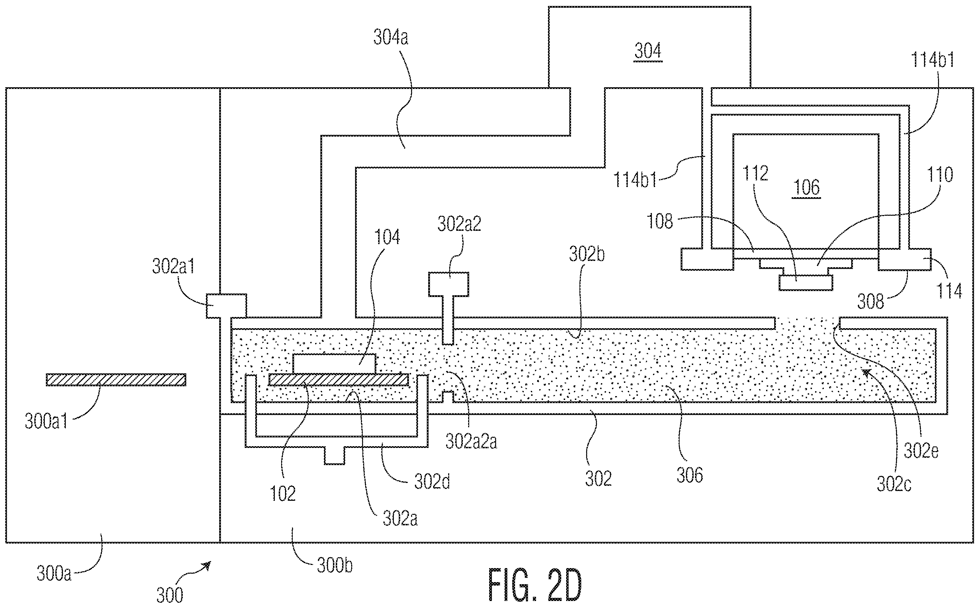

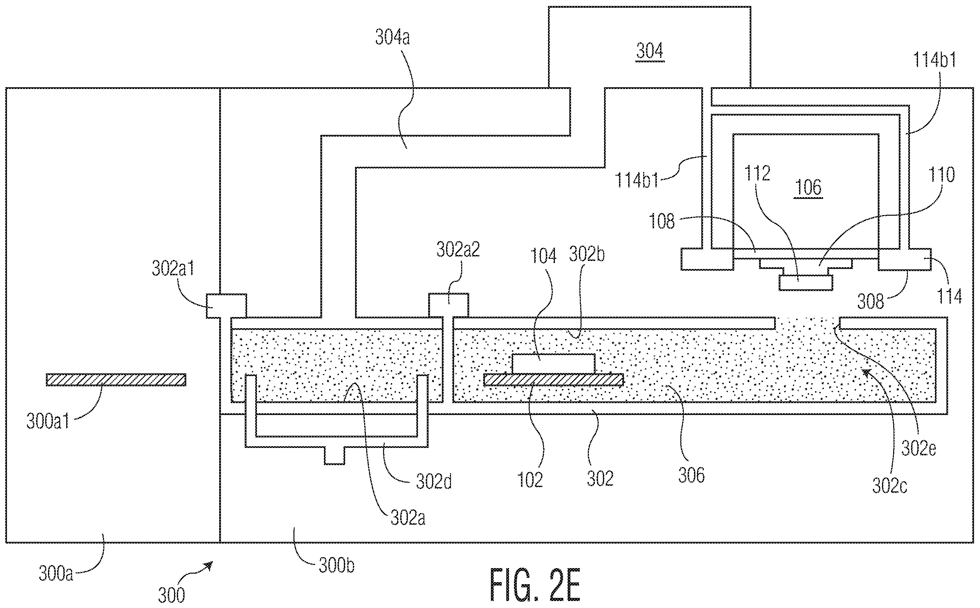

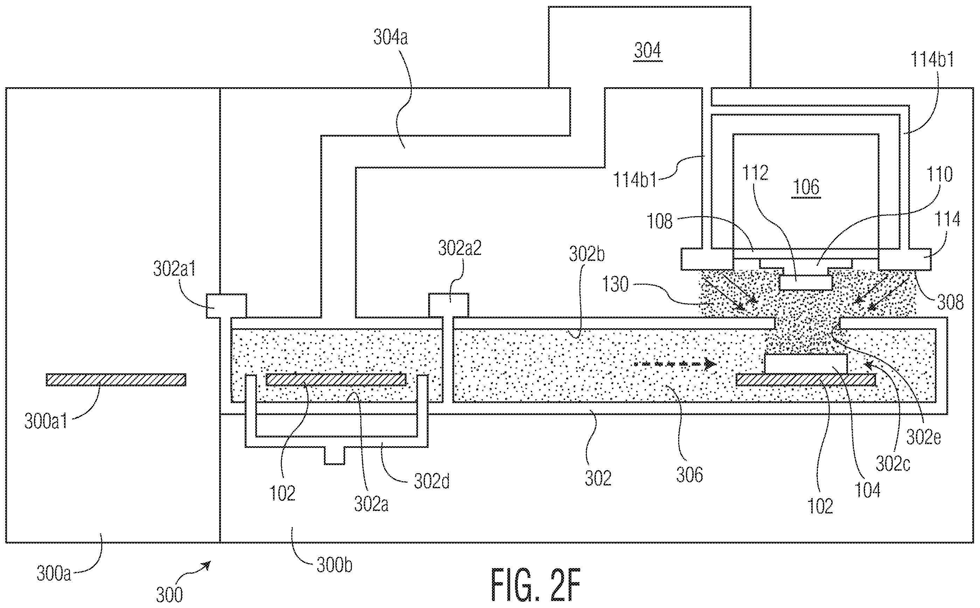

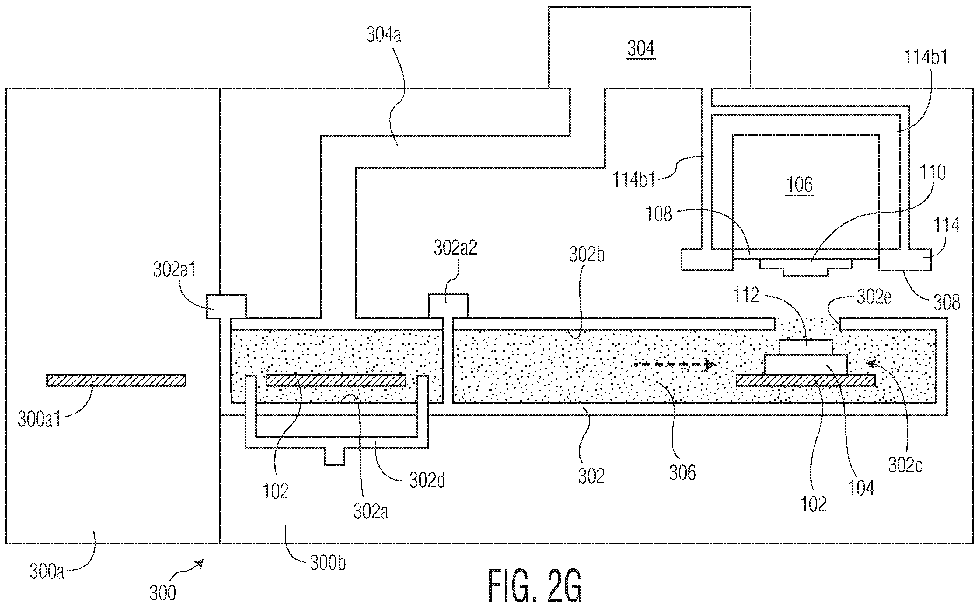

FIG. 2A-2G illustrate a method of bonding a semiconductor element 112 to a substrate 104 in connection with an exemplary embodiment of the invention, using bonding system 300 shown in FIG. 1A. FIG. 2A illustrates a substrate 104 in substrate source 300a, with entry door 302a1 in an open position. Substrate oxide reduction chamber 302a and substrate oxide prevention chamber 302b have an inert environment 306 (e.g., a nitrogen enviroment). At FIG. 2B, substrate 104 has been moved into substrate oxide reduction chamber 302a through opening 302a1a using a substrate handling system (e.g., a material handling system including support structure 102). At FIG. 2C, entry door 302a1 is closed, and a reducing gas 130 (e.g., formic acid vapor) is provided in substrate oxide reduction chamber 302a via reducing gas delivery system 302d. Reducing gas 130 removes residual oxide from the metal and solder pads (i.e., conductive structures) on substrate 104. At FIG. 2D, exit door 302a2 is opened, and substrate 104 is transferred from substrate oxide reduction chamber 302a to substrate oxide prevention chamber 302b as shown in FIG. 2E. Substrate oxide prevention chamber 302b includes an inert environment 306 (e.g., a nitrogen environment). In FIG. 2F, substrate 104 has been moved (e.g., using a material handling system including support structure 102) to bonding location 302c. At bonding location 302c, a reducing gas 130 is directed from bond head manifold 114 toward semiconductor element 112 and substrate 104. This reducing gas 130 is provided during bonding of semiconductor element 112 to substrate 104 to reduce/remove oxides on semiconductor element 112 as well as any remaining residual oxides on substrate 104. At FIG. 2G, semiconductor element 112 has been bonded to substrate 104 using bond head assembly 106.

Although FIGS. 2A-2G illustrate bonding system 300, it is contemplated that a substantially similar process could be applied to bonding system 400 shown in FIG. 1B, or other bonding systems within the scope of the invention.

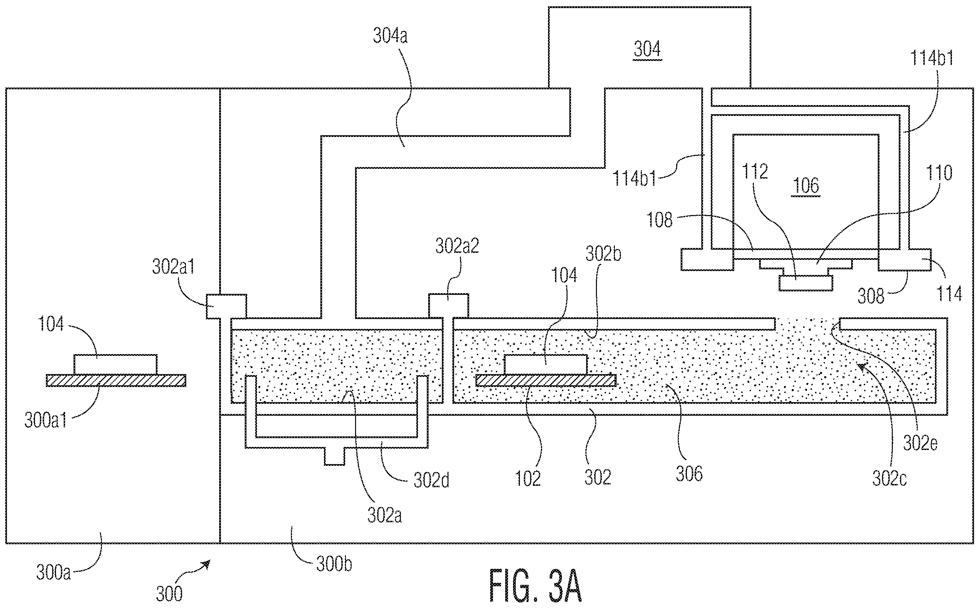

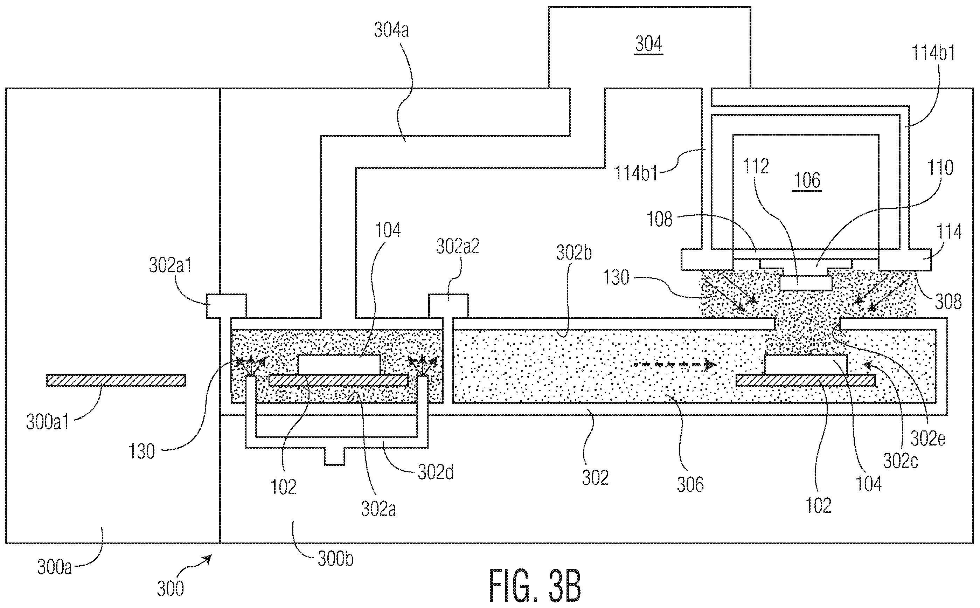

While the exemplary process of FIGS. 2A-2G illustrates a single substrate 104, it is contemplated that a plurality of substrates 104 may be involved in system 300 (or bonding system 400 of FIG. 1B) (or another bonding system within the scope of the invention). Thus, FIGS. 3A-3B illustrate multiple substrates 104. In FIG. 3A, a first substrate 104 (already having been processed using substrate oxide reduction chamber 302a) is being moved to bonding location 302c of substrate oxide prevention chamber 302b. In FIG. 3B, while that substrate 104 is at bonding location 302c, another substrate 104 is in substrate oxide reduction chamber 302a (e.g., for cleaning of conductive structures on the another substrate 104).

Exemplary aspects of the invention provides an opportunity to rework a substrate 104 (e.g., to transfer the substrate back to substrate oxide reduction chamber 302a). For example, such an approach might be useful in situations where prolonged substrate exposures to heating is unavoidable, for example, bonding of small dies (e.g. 0.1-1mm edge size) to a large area (e.g. 200-300 mm diameter substrate).

The invention may provide a number of benefits such as, for example: fluxless bonding (e.g., no fluxing of the semiconductor element or the substrate is required prior to or during bonding); reduction of oxides (e.g., metal oxides such as Cu and Sn oxides formed on pads/bumps) on both the semiconductor element and the substrate, as well as prevention of oxide formation during long heat exposures; a low consumption of nitrogen gas (or other gas providing the inert enviroment in the substrate oxide prevention chamber); and a pre-cleaning chamber, an inert gas chamber, and an in-situ oxide cleaning bond head are all provided in the same bonding system.

While it is not explicitly shown in FIGS. 1A-1B, FIGS. 2A-2G, and FIGS. 3A-3B, it is understood that a bonding operation may include bonding a semiconductor element 112 (or a plurality of elements) to a portion of the bond sites (bonding areas) of substrate 104 in the tunnel (e.g., tunnel 302/402). For example, that portion of the bond sites of substrate 104 may be exposed by an opening in the tunnel 302/402, where the bonding tool may be lowered through opening 302e/402e to complete the bonding operation. By only exposing a portion of substrate 104 at a time, the environment within tunnel 302/402e is better maintained.

In connection with bonding (e.g., thermocompression bonding) of a semiconductor element 112 (including electrically conductive structures) to a substrate 104 (including electrically conductive structures), heat may be provided through bonding tool 110 (e.g., from a heater of bond head assembly 106). A reducing gas may also be provided for cleaning oxides and/or other contaminants on the surface of the electrically conductive structures (of semiconductor element 112 and/or substrate 104).

In specific examples of such methods, a semiconductor element 112 (e.g., a semiconductor chip) is transferred from a source (e.g., a semiconductor wafer) to bonding tool 110 of a thermocompression bonding machine or a flip chip bonding machine. With semiconductor element 112 carried by bonding tool 110 (e.g., using vaccum), bond head assembly 106 (carrying bonding tool 110) is moved to a desired bonding position. The semiconductor element 112 is bonded to the bonding position of substrate 104 (e.g., while heating the semiconductor element 112 and/or the substrate 104) (e.g., where the bonding occurs in the presence of a reducing gas). The respective conductive structures of the semiconductor element 112, and/or the substrate 104 may include a solder material (e.g., the conductive structures may include a solder material at a contact surface, the conductive structures may be formed of a solder material, etc.), or the conductive structures may be formed of another conductive material (e.g., copper).

Throughout the various drawings (including FIGS. 4-9, FIGS. 10A-10D, and FIGS. 11A-11D), like reference numerals refer to the like elements, except where explained herein.

Referring now to FIG. 4, a bonding machine 100 (e.g., a flip chip bonding machine, a thermocompression bonding machine, etc.) is provided. Bonding machine 100 includes a support structure 102 for supporting a substrate 104 during a bonding operation (where substrate 104 includes a plurality of electrically conductive structures 104a). Support structure 102 may include any appropriate structure for the specific application. In FIGS. 4-9 and FIGS. 10A-10D, support structure 102 includes top plate 102a (configured to directly support substrate 104), chuck 102c, and heater 102b disposed therebetween. In applications where heat for heating substrate 104 is desirable in connection with the bonding operation, a heater such as heater 102b may be utilized.

FIG. 4 also illustrates bond head assembly 106, which may be configured to move along (and about) a plurality of axes of bonding machine 100 such as, for example, the x-axis, y-axis, z-axis, theta (rotative) axis, etc. Bond head assembly 106 includes heater 108 and bonding tool 110. That is, in certain bonding machines (e.g., thermocompression bonding machines) it may be desirable to heat the bonding tool. Thus, while FIG. 4 illustrates a separate heater 108 for heating bonding tool 110 (for heating semiconductor element 112 including a plurality of electrically conductive structures 112a), it will be appreciated that heater 108 and bonding tool 110 may be integrated into a single element (e.g., a heated bonding tool).

In connection with a bonding operation, semiconductor element 112 is bonded to substrate 104 using bonding tool 110. During the bonding operation, corresponding ones of electrically conductive structures 112a are bonded (e.g., using heat, force, ultrasonic energy, etc.) to respective ones of electrically conductive structures 104a. In FIG. 4, electrically conductive structures 112a include a solder material 112a1 at a contact portion of each electrically conductive structure 112a (e.g., a portion configured to contact the electrically conductive structures 104a of substrate 104).

In certain bonding applications (e.g., flip chip and/or thermocompression bonding with copper conductive structures), it is desirable to provide an environment suitable for bonding. Conventionally, such an environment may be provided by using a reducing gas at the bonding area to reduce potential contamination of the electrically conductive structures of the semiconductor element or the substrate to which it will be bonded.

In FIG. 4, bond head assembly 106 carries a bond head manifold 114 for receiving and distributing fluids (e.g., gases, vapors, etc.) as desired in the given application. In FIG. 4, while bond head manifold 114 is illustrated in a cross sectional view, the actual bond head manifold 114 surrounds bonding tool 110 (e.g., bond head manifold 114 surrounds bonding tool 110 in a coaxial configuration). Of course, bond head manifold 114 may have different configurations from that shown in FIG. 4. Further, it is understood that certain details of bond head manifold 114 (e.g., interconnection with piping 120, structural details for distributing a reducing gas within bond head manifold 114, structural details for distributing a shielding gas within bond head manifold 114, structural details for drawing a vacuum through a center channel of bond head manifold 114, etc.) are omitted for simplicity.

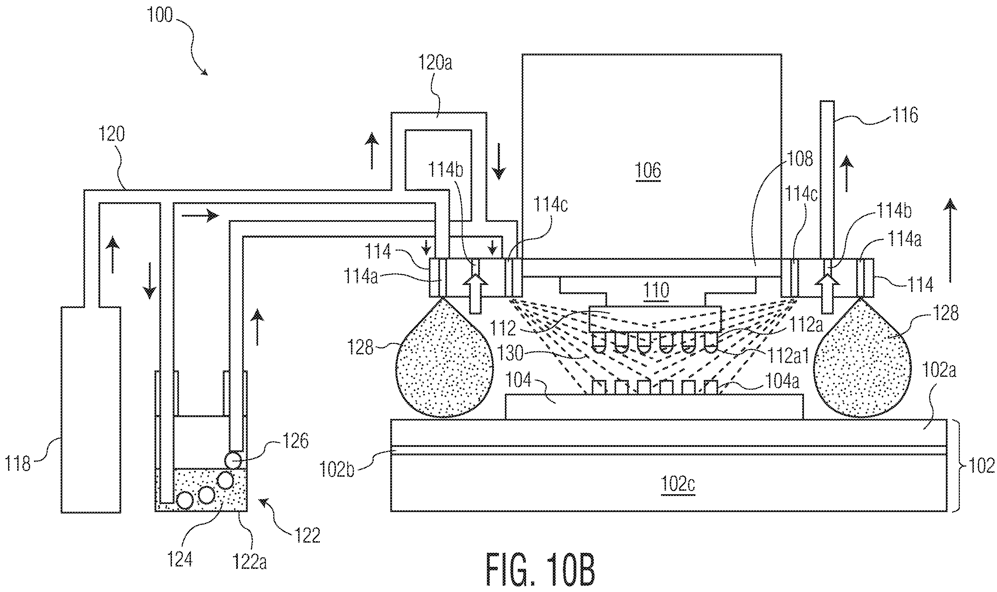

Bond head manifold 114 includes three channels 114a, 114b, 114c having different functions. Outer channel 114a receives a shielding gas (e.g., nitrogen gas) from shielding gas supply 118. That is, a shielding gas is provided from shielding gas supply 118 (e.g., a nitrogen supply), through piping 120 (where piping 120 may include hard piping, flexible tubing, a combination of both, or any other structure adapted to carry the fluids described herein), to outer channel 114a of bond head manifold 114. From outer channel 114a of bond head manifold 114, the shielding gas 128 is provided as a shield from the outside environment (e.g., see FIGS. 10B-10C).

Inner channel 114c receives a reducing gas 130 (e.g., see FIGS. 10B-10C) (e.g., where the reducing gas is a saturated vapor gas) via piping 120, and provides reducing gas 130 in the area of semiconductor element 112 and substrate 104 in connection with a bonding operation. Reducing gas 130 is provided by a vapor generation system 122, but initiates as reducing gas 126. In the example shown in FIG. 4, vapor generation system 122 is a bubbler type system including an acid fluid 124 (e.g., formic acid, acetic acid, etc.) in vessel 122a of the bubbler type system. A carrier gas (e.g., nitrogen) is provided (via piping 120) into acid fluid 124 in vessel 122a, where the carrier gas acts as a carrier for the acid fluid 124. Collectively, the carrier gas (e.g., nitrogen) and acid fluid 124 are transported as reducing gas 126. Within piping 120, additional carrier gas (e.g., nitrogen) may be added to reducing gas 126 (e.g., to vary the concentration of the reducing gas, as desired) via piping section 120a, thereby providing reducing gas 130 in the area of semiconductor element 112 and substrate 104 in connection with the bonding operation. After reducing gas 130 is distributed in the area of semiconductor element 112 and substrate 104, reducing gas 130 contacts surfaces of each of electrically conductive structures 104a and electrically conductive structures 112a (e.g., see FIG. 10B). The surfaces of electrically conductive structures 104a/112a may then include a reaction product (e.g., where the reaction product is provided as a result of (i) a surface oxide on electrically conductive structures 104a/112a, and (ii) reducing gas from reducing gas 130 (and possibly heat provided by heater 108 and transferred to electrically conductive structures 104a via contact with electrically conductive structures 112a, if desired). This reaction product is desirably removed from the bonding area (i.e., the area where electrically conductive structures 112a of semiconductor element 112 are bonded to corresponding electrically conductive structures 104a of substrate 104) using vaccum provided through center channel 114b of bond head manifold 114 via exit piping 116.

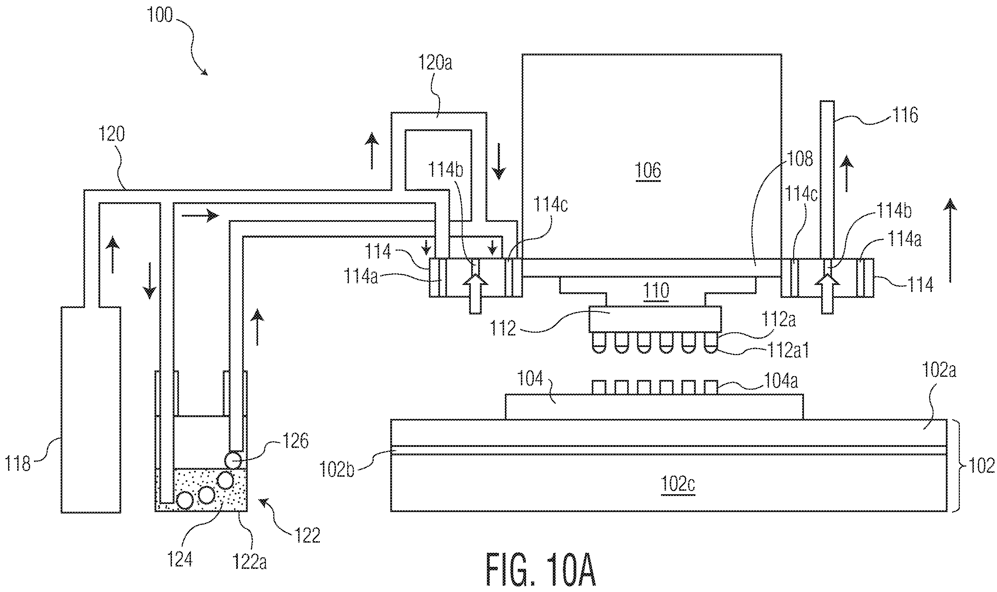

Thus, FIG. 4 illustrates: (i) various elements of bonding machine 100; (ii) a path of carrier gas from carrier gas supply 118 to outer channel 114a of bond head manifold 114; (iii) a path of reducing gas 126 (which may receive additional carrier gas from piping 120) from vapor generation system 122 to inner channel 114c of bond head manifold 114, where it is released to the bonding area as reducing gas 130; and (iv) a path of gas (which may carry away a reaction product from surfaces of electrically conductive structures 104a/112a) drawn by vacuum through center channel 114b of bond head manifold 114. The aforementioned paths are illustrated in FIG. 4 through various arrows even though gas is not flowing in FIG. 4 (see FIGS. 10A-10D for an exemplary operation).

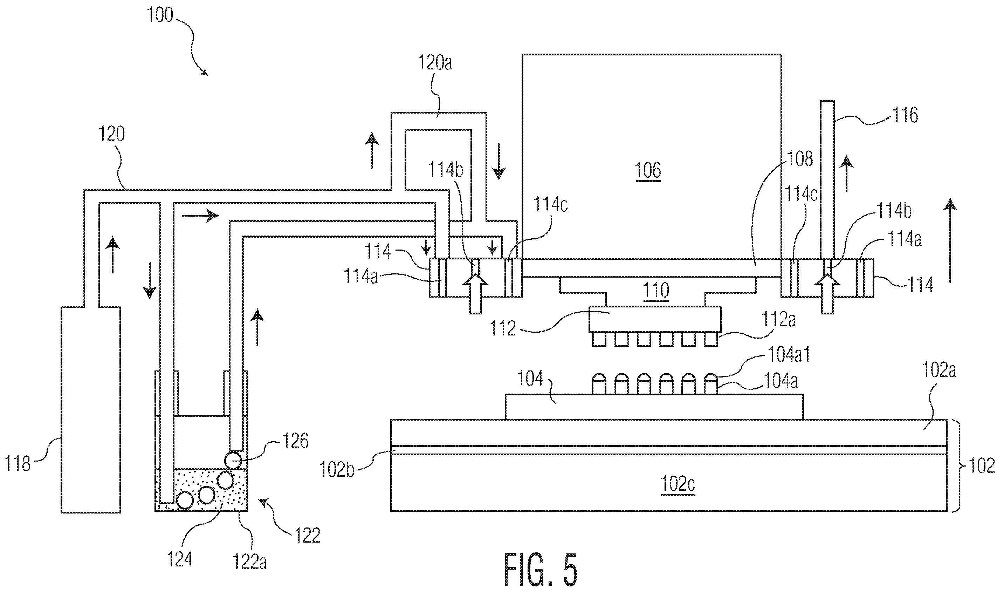

FIG. 5 again illustrates bonding machine 100 as shown in FIG. 4; however, in FIG. 5 electrically conductive structures 112a do not include a solder material 112a1 as shown in FIG. 4. Rather, in FIG. 5, electrically conductive structures 104a include a solder material 104a1 at a contact portion of each electrically conductive structure 104a (e.g., a portion configured to contact the electrically conductive structures 112a of semiconductor element 112).

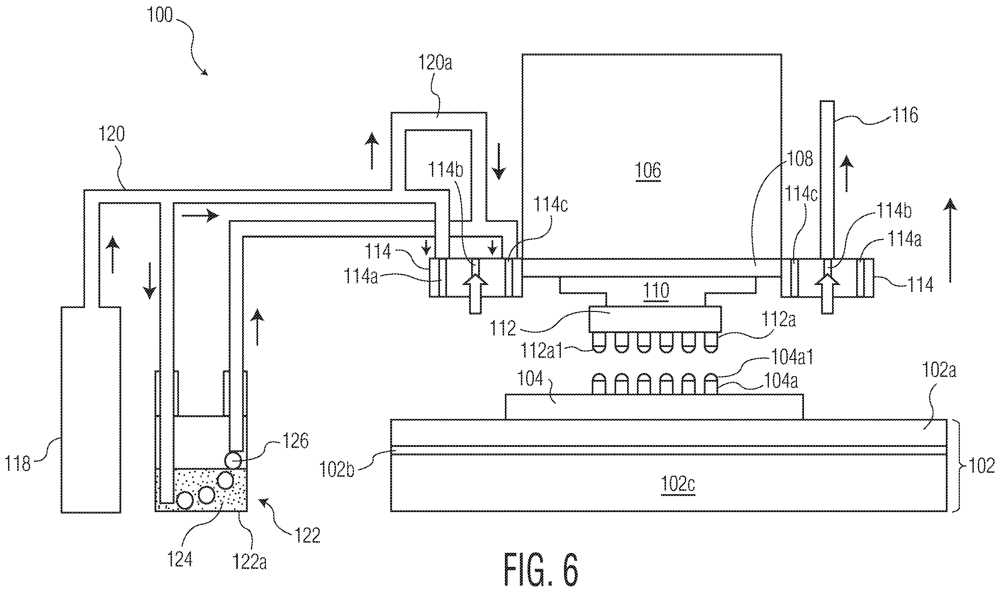

FIG. 6 again illustrates bonding machine 100 as shown in FIGS. 4-5; however, in FIG. 6 electrically conductive structures 112a include a solder material 112a1 as shown in FIG. 4, and electrically conductive structures 104a include a solder material 104a1 as shown in FIG. 5.

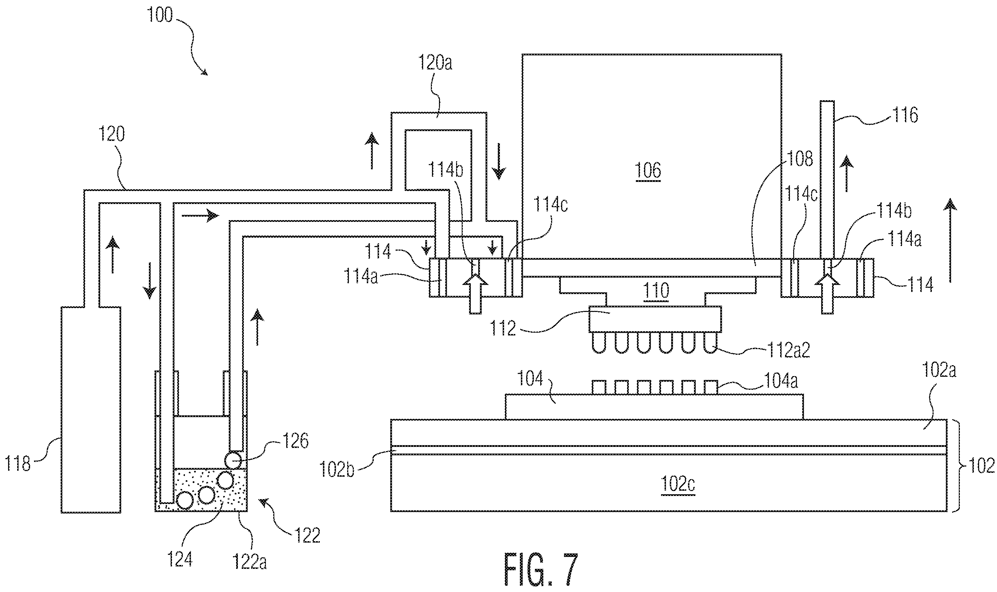

FIG. 7 again illustrates bonding machine 100 as shown in FIG. 4; however, in FIG. 7 electrically conductive structures 112a (shown in FIG. 4) are replaced by electrically conductive structures 112a2 which are formed of a solder material. That is, unlike FIG. 4, where electrically conductive structures 112a includes a solder material 112a1 at a contact portion, in FIG. 7, electrically conductive structures 112a2 are fully formed of a solder material.

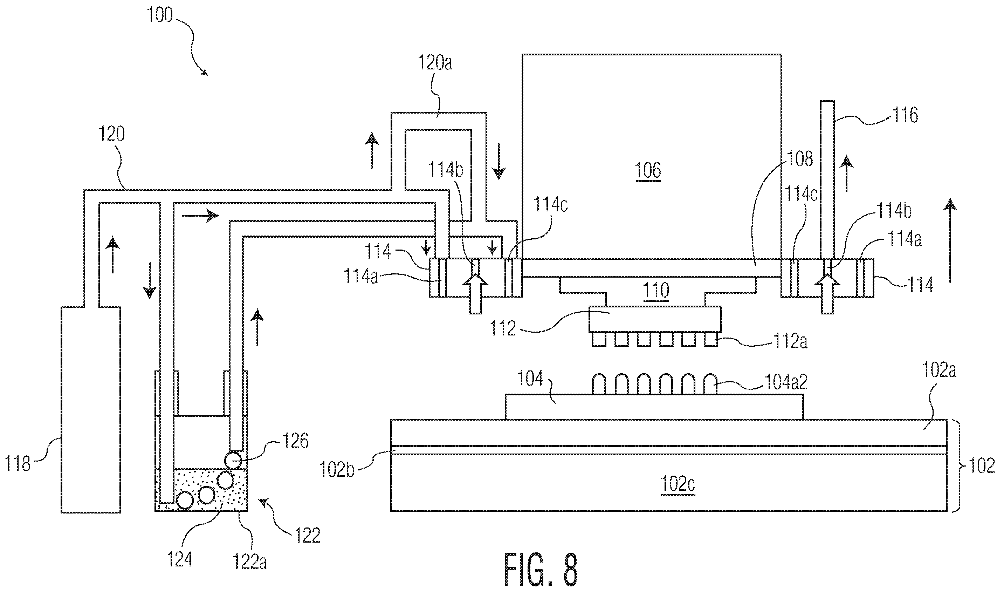

FIG. 8 again illustrates bonding machine 100 as shown in FIG. 5; however, in FIG. 8 electrically conductive structures 104a (shown in FIG. 5) are replaced by electrically conductive structures 104a2 which are formed of a solder material. That is, unlike FIG. 5, where electrically conductive structures 104a includes a solder material 104a1 at a contact portion, in FIG. 8, electrically conductive structures 104a2 are fully formed of a solder material.

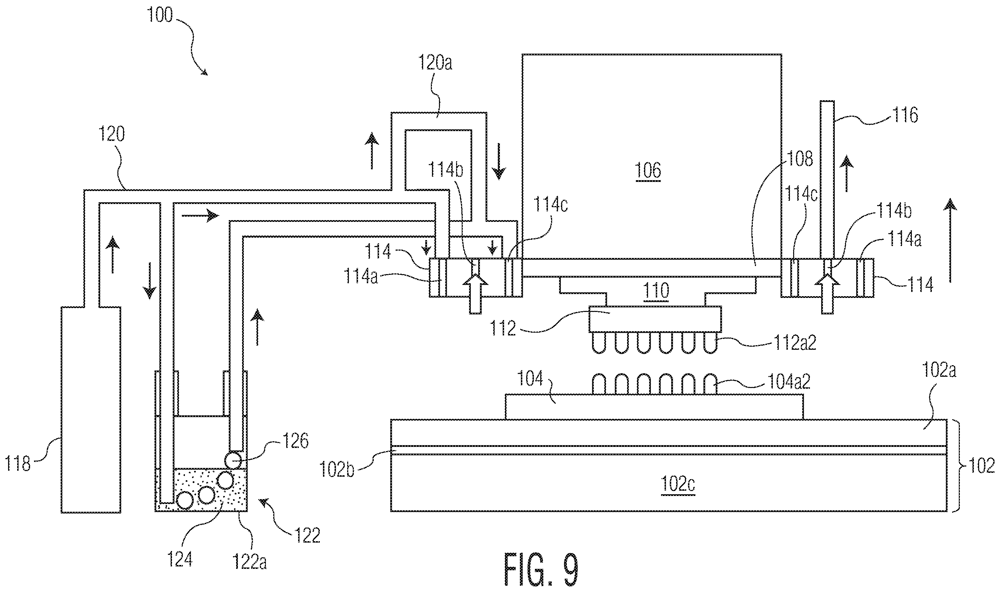

FIG. 9 again illustrates bonding machine 100 as shown in FIGS. 4-8; however, in FIG. 9 electrically conductive structures 112a (shown in FIGS. 4 and 6, including a solder material 112a1) are replaced by electrically conductive structures 112a2 (fully formed of a solder material) as shown in FIG. 7. Further, in FIG. 9, electrically conductive structures 104a (shown in FIG. 5, including a solder material 104a1) are replaced by electrically conductive structures 104a2 (fully formed of a solder material) as shown in FIG. 8.

Thus, according to certain aspects of the invention the electrically conductive structures of the semiconductor element being bonded, or the substrate configured to receive the semiconductor element during bonded, may include a solder material. The solder material may be included in a number of different configurations. For example, the solder material may be included at a contact portion of the electrically conductive structures (e.g., see FIGS. 4-6). In another non-limiting example, the entire electrically conductive structures may be formed of the solder material (e.g., see FIGS. 7-9).

FIGS. 10A-10D and FIGS. 11A-11D are block diagrams illustrating methods of bonding a semiconductor element to a substrate. In each of FIGS. 10A-10D and FIGS. 11A-11D: (i) the semiconductor element 112 (with electrically conductive structures 112a including solder material 112a1 at a contact portion) is shown as in FIG. 4; and (ii) the substrate 104 (with electrically conductive structures 104a not including a solder material) is shown as in FIG. 4. However, it is understood that the methods shown and described with respect to FIGS. 10A-10D and FIGS. 11A-11D are equally applicable to the semiconductor elements and substrates of each of FIGS. 4-9, and are applicable to the semiconductor elements and substrates of any other embodiment within the scope of the invention.

Prior to the processes shown and described in connection with FIGS. 10A-10D and FIGS. 11A-11D, semiconductor element 112 and/or substrate 104 may be "cleaned". For example, the electrically conductive structures 112a, 104a of one or both of semiconductor element 112 and substrate 104 may be cleaned using a solution such as hydrochloric acid or acetic acid. Such a cleaning step may be performed, for example, by dipping at least a portion of semiconductor element 112 and/or substrate 104 into such a solution.

Referring now to FIG. 10A, semiconductor element 112 (carried by bond head 106) is positioned above substrate 104. As shown in FIG. 10B, vapor generation system 122 has been activated to produce reducing gas 130 at the bonding area. More specifically, FIG. 10B illustrates reducing gas 130 being provided at the bonding area, as well as shielding gas 128 being provided, and vacuum being drawn through center channel 114b of bond head manifold 114 via exit piping 116. Thus, the flow of reducing gas 130 reach desired portions of semiconductor element 112 and substrate 104 (e.g., electrically conductive structures 104a and electrically conductive structures 112a) for: removing contaminants from the electrically conductive structures 104a and electrically conductive structures 112a; and/or shielding electrically conductive structures 104a and electrically conductive structures 112a from further potential contamination.

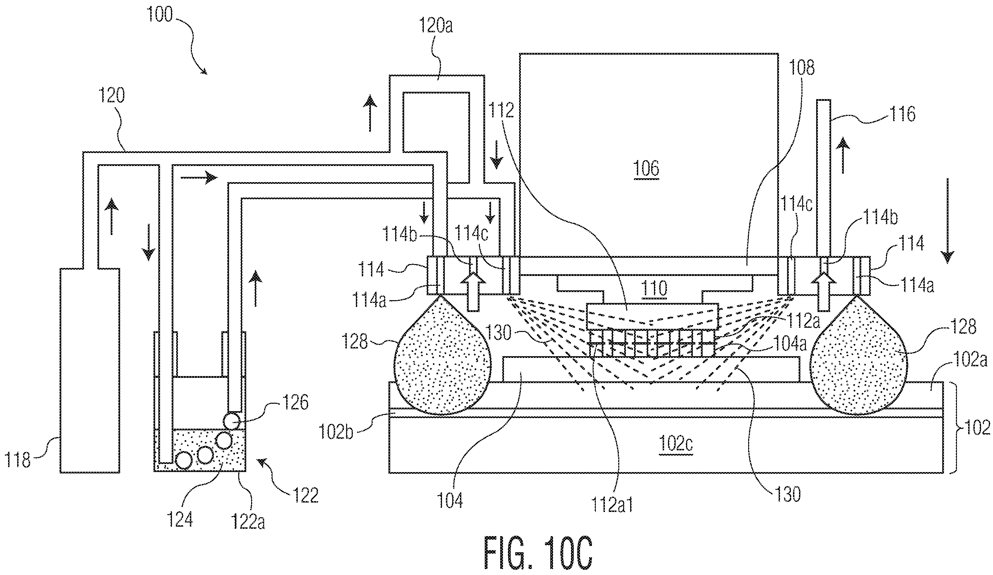

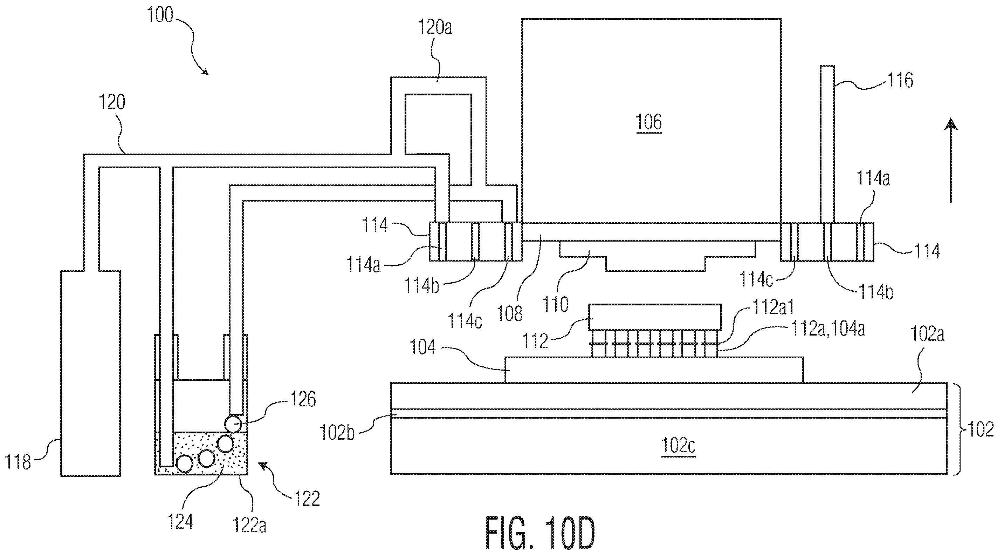

Also shown in FIG. 10B, respective ones of electrically conductive structures 112a (of semiconductor element 112) are aligned with ones of electrically condutive structures 104a (of substrate 104). At FIG. 10C, the process proceeds to a bonding step (e.g., a thermocompression bonding step), for example, through the lowering of bond head 106. That is, electrically conductive structures 112a are bonded to corresponding electrically conductive structures 104a. This may be through a thermocompression bonding process (e.g., including heat and/or bond force, where the bond force may be a higher bond force such as 50-300 N), and may also include ultrasonic energy transfer (e.g., from an ultrasonic transducer included in bond head assembly 106). At FIG. 10D, the bonding process has been completed. That is, semiconductor element 112 has been bonded to substrate 104, such that corresponding electrically conductive structures 112a, 104a are now bonded to one another with deformed solder materual 112a1 provided therebetween.

Although FIGS. 10A-10D (and FIGS. 4-9) illustrate manifold 114, integrated with the bond head, for: delivering the reducing gas; delivering the shielding gas; and providing vaccum - the invention is not limited thereto. For example, instead of such functions being provided through integration of a manifold with the bond head assembly, such functions may be provided through integration with a support structure for supporting the substrate. Further, such functions may be split between the bond head assembly and the support structure (and possibly other structures of the bonding machine). FIGS. 11A-11D are a series of block diagrams of a bonding machine 100", with certain similar elements and functions to that illustrated and described with respect to FIG. 4 and FIGS. 10A-10D, except that the manifold functions (delivering the reducing gas; delivering the shielding gas; and providing vaccum) are integrated into a support structure 202.

FIG. 11A illustrates bonding machine 100" (e.g., a flip chip bonding machine, a thermocompression bonding machine, etc.). Bonding machine 100" includes a support structure 202 for supporting a substrate 104 during a bonding operation (where substrate 104 includes a plurality of electrically conductive structures 104a). Support structure 202 may include any appropriate structure for the specific application. In FIGS. 11A-11D, support structure 202 includes top plate 202a (configured to directly support substrate 104), chuck 202c, and heater 202b disposed therebetween. In applications where heat for heating substrate 104 is desirable in connection with the bonding operation, a heater such as heater 202b may be utilized.

FIG. 11A also illustrates bond head assembly 106 (including heater 108 and bonding tool 110), which may be configured to move along (and about) a plurality of axes of bonding machine 100" such as, for example, the x-axis, y-axis, z-axis, theta (rotative) axis, etc. In FIG. 11A, bond head assembly 106 carries a plate 107 for partially containing at least one of shielding gas 128 and reducing gas 130 (see description below).

As opposed to a bond head manifold 114 carried by bond head assembly 106 (as in FIGS. 10A-10D), FIGS. 11A-11D illustrate a manifold 214 carried by, and/or integrated with, support structure 202. Manifold 214 is configured for receiving and distributing fluids (e.g., gases, vapors, etc.) as desired in the given application. In FIG. 11A, while manifold 214 is illustrated in a cross sectional view, the actual manifold 214 at least partially surrounds substrate 104. Of course, manifold 214 may have different configurations from that shown in FIG. 11A. Further, it is understood that certain details of manifold 214 (e.g., interconnection with piping 120, structural details for distributing reducing gas 130 within manifold 214, structural details for distributing shielding gas 128 within manifold 214, structural details for drawing a vacuum through a center channel of manifold 214, etc.) are omitted for simplicity.

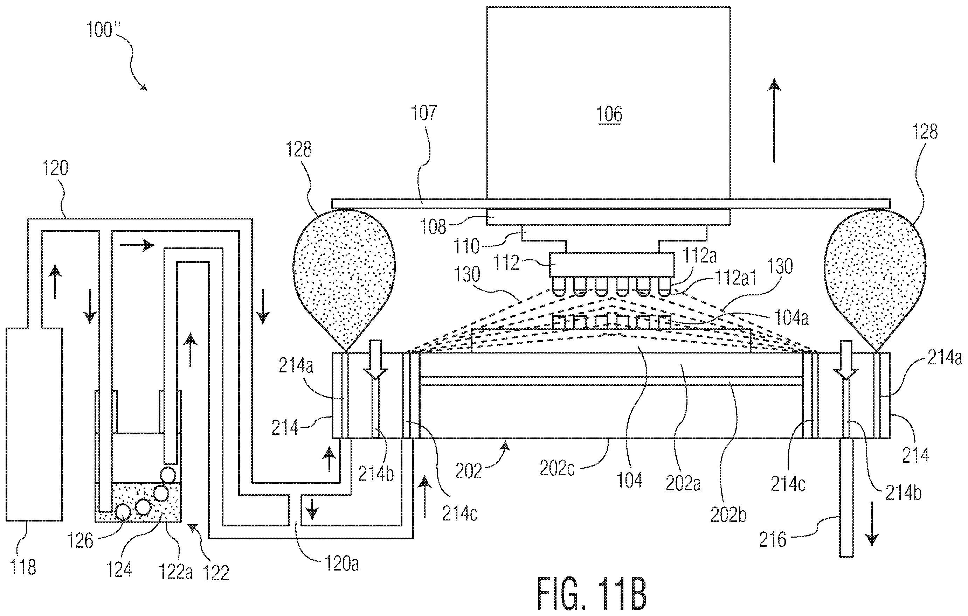

Manifold 214 includes three channels 214a, 214b, 214c having different functions. Outer channel 214a receives shielding gas 128 (e.g., nitrogen gas) from shielding gas supply 118 via piping 120. From outer channel 214a of manifold 214, shielding gas 128 is provided as a shield from the outside environment (e.g., see FIGS. 11B-11C). Inner channel 214c receives a reducing gas 130 (e.g., see FIGS. 11B-11C) (e.g., where the reducing gas is a saturated vapor gas) via piping 120, and provides reducing gas 130 in the area of semiconductor element 112 and substrate 104 in connection with a bonding operation. Reducing gas 130 is provided by a vapor generation system 122, but initiates as reducing gas 126 (e.g., see description above with respect to FIG. 4). After reducing gas 130 is distributed in the area of semiconductor element 112 and substrate 104, reducing gas 130 contacts surfaces of each of electrically conductive structures 104a and electrically conductive structures 112a. The surfaces of electrically conductive structures 104a/112a may then include a reaction product (e.g., where the reaction product is provided as a result of: (i) a surface oxide on electrically conductive structures 104a/112a, and (ii) reducing gas from reducing gas 130 (and possibly heat provided by heater 108, if desired). This reaction product is desirably removed from the bonding area (i.e., the area where electrically conductive structures 112a of semiconductor element 112 are bonded to corresponding electrically conductive structures 104a of substrate 104) using vaccum provided through center channel 214b of manifold 214 via exit piping 216.

Thus, FIG. 11A illustrates: (i) various elements of bonding machine 100"; (ii) a path of carrier gas from carrier gas supply 118 to outer channel 214a of manifold 214; (iii) a path of reducing gas 126 (which may receive additional carrier gas from piping 120a) from vapor generation system 122 to inner channel 214c of manifold 214, where it is released to the bonding area as reducing gas 130; and (iv) a path of gas (which may carry away a reaction product from surfaces of electrically conductive structures 104a/112a) drawn by vacuum through center channel 214b of manifold 214. The aforementioned paths are illustrated in FIG. 11A through various arrows even though gas is not flowing in FIG. 11A.

Referring now to FIG. 11A, semiconductor element 112 (carried by bond head 106) is positioned above substrate 104. As shown in FIG. 11B, vapor generation system 122 has been activated to produce reducing gas 130 at the bonding area. More specifically, FIG. 11B illustrates reducing gas 130 being provided at the bonding area, as well as shielding gas 128 being provided, and vacuum being drawn through center channel 214b of manifold 214 via exit piping 116. Thus, the flow of reducing gas 130 reach desired portions of semiconductor element 112 and substrate 104 (e.g., electrically conductive structures 104a and electrically conductive structures 112a) for: removing contaminants from the electrically conductive structures 104a and electrically conductive structures 112a; and/or shielding electrically conductive structures 104a and electrically conductive structures 112a from further potential contamination.

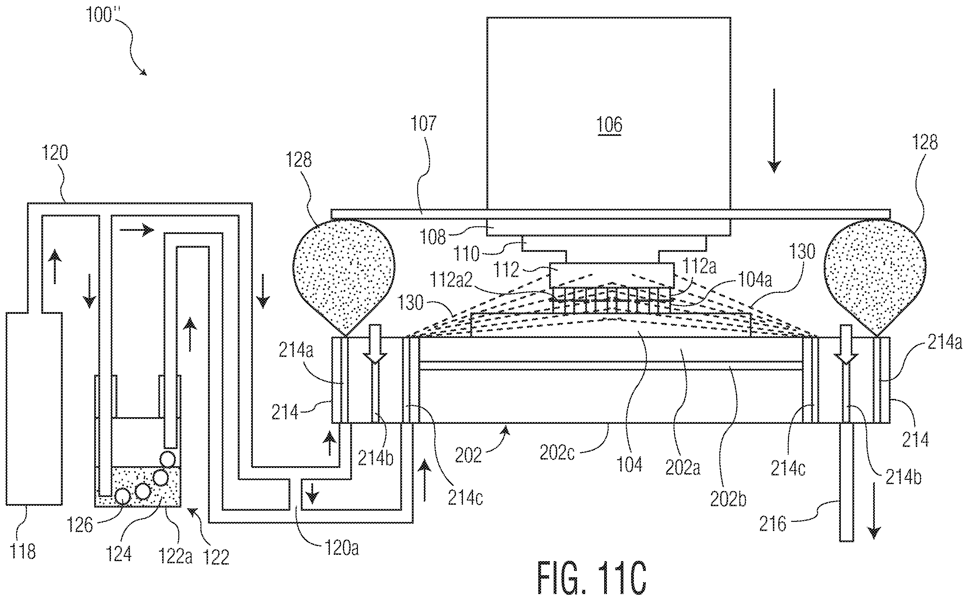

Also shown in FIG. 11B, respective ones of electrically conductive structures 112a (of semiconductor element 112) are aligned with ones of electrically conductive structures 104a (of substrate 104). At FIG. 11C, the process proceeds to a bonding step (e.g., a thermocompression bonding step), for example, through the lowering of bond head 106. That is, electrically conductive structures 112a are bonded to corresponding electrically conductive structures 104a. This may be through a thermocompression the bonding process has been completed. That is, semiconductor element 112 has been bonded to substrate 104, such that corresponding electrically conductive structures 112a, 104a are now bonded to one another with deformed solder material 112a2 provided therebetween.

Although the disclosure has been illustrated primarily with respect to one of manifolds 114, 214 for directing (i) the flow of reducing gas 130, (ii) the flow of shielding gas 128, and (iii) the pull of the vacuum, it is understood that the structure used to direct the flow patterns may be different from that illustrated. That is, the configuration of the structure used to provide and direct fluids 130, 128 (and to draw vacuum) may vary considerably from that shown.

The bonding machines described herein in connection with FIGS. 4-9, FIGS. 10A-10D, and FIGS. 11A-11D may provide a number of benefits such as, for example: fluxless bonding (e.g., no fluxing of the semiconductor element or the substrate is required prior to or during bonding); reduction of oxides on both the semiconductor element and the substrate; among others.

It will be appreciated by those skilled in the art that certain elements of bonding machine 100 (see FIGS. 4-9 and FIGS. 10A-10D), and/or bonding machine 100" (see FIGS. 11A-11D) may be integrated into the systems of FIG. 1, FIGS. 2A-2G, and (e.g., the bond head, the shroud, certain piping, etc.).

Although the invention has been described and illustrated with respect to the exemplary embodiments thereof, it should be understood by those skilled in the art that the foregoing and various other changes, omissions and additions may be made therein and thereto. Rather, various modifications may be made in the details, the scope of the invention being defined solely by the appended claims.

## Claims

1. A bonding system (300, 400) for bonding a semiconductor element to a substrate, the bonding system comprising:
a substrate oxide reduction chamber (302a, 402a) configured to receive a substrate (104), the substrate including a plurality of first electrically conductive structures, the substrate oxide reduction chamber configured to receive a reducing gas (130) to contact each of the plurality of first electrically conductive structures;
a substrate oxide prevention chamber (302b, 402b) for receiving the substrate after the reducing gas contacts the plurality of first electrically conductive structures, the substrate oxide prevention chamber capable of having an inert environment (306, 406) when receiving the substrate; a substrate support structure (102) for supporting the substrate during bonding of the semiconductor element to the substrate; and
a reducing gas delivery system (308, 408) for providing a reducing gas environment at a bonding location (302c, 402c) of the substrate oxide prevention chamber (302b, 402b) during bonding of a semiconductor element (112) to the substrate, the semiconductor element including a plurality of second electrically conductive structures, the plurality of first electrically conductive structures being configured to be bonded with corresponding ones of the plurality of second electrically conductive structures, **characterized by** further comprising
a bond head including a bonding tool (110) for bonding the semiconductor element to the substrate, wherein the reducing gas delivery system is integrated with the bond head; or
wherein the reducing gas delivery system is integrated with the substrate support structure.

2. The bonding system (300, 400) of claim 1 further comprising a substrate transfer system for transferring the substrate (104) from the substrate oxide reduction chamber (302a, 402a) to the substrate oxide prevention chamber.

3. The bonding system (300, 400) of claim 1 or 2, wherein the substrate oxide prevention chamber (302b, 402b) is provided with nitrogen to create the inert environment.

4. The bonding (300, 400) system of any previous claim, further comprising a material handling system for moving the substrate (104) within the substrate oxide prevention chamber (302b, 402b).

5. The bonding system (300, 400) of any previous claim, wherein the substrate oxide prevention chamber (302b, 402b) includes the bonding location (302c, 402c) for receiving the substrate during bonding of the semiconductor element to the substrate (104).

6. The bonding system (300, 400) of any previous claim, wherein the semiconductor element is a semiconductor die.

7. The bonding system (300, 400) of claim 6 wherein the substrate (104) is a semiconductor wafer.

8. The bonding system (300, 400) of any previous claim, wherein at least a portion of the substrate oxide reduction chamber (302a, 402a) has a common boundary with the substrate oxide prevention chamber.

9. A method of bonding a semiconductor element (112) to a substrate (104), the method comprising the steps of:
supporting a substrate (104) with a substrate support structure (102);
moving the substrate (104) into a substrate oxide reduction chamber (302a, 402a), the substrate including a plurality of first electrically conductive structures, the substrate oxide reduction chamber configured to receive a reducing gas (130) to contact each of the plurality of first electrically conductive structures;
moving the substrate into a substrate oxide prevention chamber (302b, 402b) after the reducing gas contacts the plurality of first electrically conductive structures, the substrate oxide prevention chamber having an inert environment (306, 406) when receiving the substrate; and
bonding the semiconductor element (112) to the substrate (104) at a bonding location (302c,402c) using a bonding head including a bonding tool (110); and
providing a reducing gas environment at the bonding location (302c, 402c) of the substrate oxide prevention chamber (302b, 402b) during the bonding of the semiconductor element (112) to the substrate, the semiconductor element including a plurality of second electrically conductive structures, the plurality of first electrically conductive structures being configured to be bonded with corresponding ones of the plurality of second electrically conductive structures; **characterized in that**
the reducing gas environment is provided by a reducing gas delivery system (308, 408) integrated with the bond head or with the substrate support structure (102).

10. The method of claim 9 further comprising the step of transferring the substrate (104) from the substrate oxide reduction chamber (302a, 402a) to the substrate oxide prevention chamber (302b, 402b) using a substrate transfer system.

11. The method of claim 9 or 10, further comprising the step of providing nitrogen in the substrate oxide prevention chamber (302b, 402b) to create the inert environment.

## Patentansprüche

1. Ein Verbindungssystem (300, 400) zum Verbinden eines Halbleiterelements mit einem Substrat, wobei das Verbindungssystem umfasst:
eine Substratoxid-Reduktionskammer (302a, 402a), die dazu vorgesehen ist, ein Substrat (104) aufzunehmen, wobei das Substrat eine Vielzahl erster elektrisch leitfähiger Strukturen umfasst und die Substratoxid-Reduktionskammer dazu vorgesehen ist, ein Reduktionsgas (130) zu fassen, um es mit jeder einzelnen der Vielzahl erster elektrisch leitfähiger Strukturen in Kontakt zu bringen;
eine Substratoxid-Vorbeugungskammer (302b, 402b) , die dazu dient, das Substrat aufzunehmen, nachdem das Reduktionsgas mit der Vielzahl erster elektrisch leitfähiger Strukturen in Kontakt gekommen ist, wobei die Substratoxid-Vorbeugungskammer in der Lage ist, bei Aufnahme des Substrats eine inerte Umgebung (306, 406) anzunehmen;
eine Substrat-Auflagestruktur (102) zum Tragen des Substrats während eines Verbindens des Halbleiterelements mit dem Substrat; und
ein Reduktionsgas-Zuführsystem (308, 408) zum Bereitstellen einer Reduktionsgasumgebung an einem Bondplatz (302c, 402c) der Substratoxid-Vorbeugungskammer (302b, 402b) während des Verbindens eines Halbleiterelements (112) mit dem Substrat, wobei das Halbleiterelement eine Vielzahl von zweiten elektrisch leitfähigen Strukturen umfasst und die Vielzahl von ersten elektrisch leitfähigen Strukturen dazu vorgesehen ist, mit entsprechenden der Vielzahl von zweiten elektrisch leitfähigen Strukturen verbunden zu werden, **dadurch gekennzeichnet, dass** es ferner umfasst
einen Bondkopf mit einem Bondwerkzeug (110) zum Verbinden des Halbleiterelements mit dem Substrat, wobei
das Reduktionsgas-Zuführsystem in den Bondkopf integriert ist; oder
wobei das Reduktionsgas-Zuführsystem in die Substrat-Auflagestruktur integriert ist.

2. Das Verbindungssystem (300, 400) nach Anspruch 1, das ferner ein Substrat-Transfersystem zum Transferieren des Substrats (104) von der Substratoxid-Reduktionskammer (302a, 402a) zur Substratoxid-Vorbeugungskammer umfasst.

3. Das Verbindungsystem (300, 400) nach Anspruch 1 oder 2, wobei die Substratoxid-Vorbeugungskammer (302b, 402b) mit Stickstoff versorgt wird, um die inerte Umgebung zu erzeugen.

4. Das Verbindungssystem (300, 400) nach einem der vorstehenden Ansprüche, ferner umfassend ein Materialhandhabungssystem zum Bewegen des Substrats (104) innerhalb der Substratoxid-Vorbeugungskammer (302b, 402b).

5. Das Verbindungssystem (300, 400) nach einem der vorstehenden Ansprüche, wobei die Substratoxid-Vorbeugungskammer (302b, 402b) den Bondplatz (302c, 402c) zur Aufnahme des Substrats während des Verbindens des Halbleiterelements mit dem Substrat (104) umfasst.

6. Das Verbindungsystem (300, 400) nach einem der vorstehenden Ansprüche, wobei das Halbleiterelement ein Halbleiterchip ist.

7. Das Verbindungsystem (300, 400) nach Anspruch 6, wobei das Substrat (104) ein Halbleiterwafer ist.

8. Das Verbindungssystem (300, 400) nach einem der vorstehenden Ansprüche, wobei zumindest ein Teil der Substratoxid-Reduktionskammer (302a, 402a) eine gemeinsame Grenze mit der Substratoxid-Vorbeugungskammer aufweist.

9. Verfahren zum Verbinden eines Halbleiterelements (112) mit einem Substrat (104), wobei das Verfahren die folgenden Schritte umfasst:
Tragen eines Substrats (104) auf einer Substrat-Auflagestruktur (102);
Bewegen des Substrats (104) in eine Substratoxid-Reduktionskammer (302a, 402a), wobei das Substrat eine Vielzahl erster leitfähiger Strukturen umfasst und die Substratoxid-Reduktionskammer dazu vorgesehen ist, ein Reduktionsgas (130) zu fassen, um es mit jeder einzelnen der Vielzahl erster elektrisch leitfähiger Strukturen in Kontakt zu bringen;
Bewegen des Substrats in eine Substratoxid-Vorbeugungskammer (302b, 402b) , nachdem das Reduktionsgas mit der Vielzahl erster elektrisch leitfähiger Strukturen in Kontakt gekommen ist, wobei die Substratoxid-Vorbeugungskammer bei Aufnahme des Substrats eine inerte Umgebung (306, 406) aufweist; und
Verbinden des Halbleiterelements (112) mit dem Substrat (104) an einem Bondplatz (302c, 402c) unter Verwendung eines Bondkopfes, der ein Bondwerkzeug (110) umfasst; und
Bereitstellen einer Reduktionsgasatmosphäre am Bondplatz (302c, 402c) der Substratoxid-Vorbeugungskammer (302b, 402b) während des Verbindens des Halbleiterelements (112) mit dem Substrat, wobei das Halbleiterelement eine Vielzahl von zweiten elektrisch leitfähigen Strukturen umfasst und die Vielzahl von ersten elektrisch leitfähigen Strukturen dazu vorgesehen sind, mit entsprechenden der Vielzahl von zweiten elektrisch leitfähigen Strukturen verbunden zu werden; **dadurch gekennzeichnet, dass**
die Reduktionsgasatmosphäre durch ein Reduktionsgas-Zuführsystem (308, 408) bereitgestellt wird, das in
den Bondkopf oder in
die Substrat-Auflagestruktur (102) integriert ist.

10. Verfahren nach Anspruch 9, das ferner den Schritt des Transferierens des Substrats (104) aus der Substratoxid-Reduktionskammer (302a, 402a) in die Substratoxid-Vorbeugungskammer (302b, 402b) unter Verwendung eines Substrat-Transfersystems umfasst.

11. Verfahren nach Anspruch 9 oder 10, das ferner den Schritt des Bereitstellens von Stickstoff in der Substratoxid-Vorbeugungskammer (302b, 402b) umfasst, um die inerte Umgebung zu erzeugen.

## Revendications

1. Système de liaison (300, 400) destiné à lier un élément semi-conducteur à un substrat, le système de liaison comprenant :
une chambre de réduction de l'oxyde du substrat (302a, 402a) configurée pour recevoir un substrat (104), le substrat comprenant une pluralité de premières structures électriquement conductrices, la chambre de réduction de l'oxyde du substrat étant configurée pour recevoir un gaz réducteur (130) afin de mettre en contact ce dernier avec chacune des premières structures électriquement conductrices de la pluralité ;
une chambre de prévention de l'oxydation du substrat (302b, 402b) destinée à recevoir le substrat après que le gaz réducteur est entré en contact avec la pluralité de premières structures électriquement conductrices, la chambre de prévention de l'oxydation du substrat étant capable de présenter un environnement inerte (306, 406) lors de la réception du substrat ;
une structure de support de substrat (102) destinée à supporter le substrat pendant la liaison de l'élément semi-conducteur au substrat ; et
un système d'alimentation en gaz réducteur (308, 408) destiné à créer un environnement de gaz réducteur au niveau d'un emplacement de liaison (302c, 402c) de la chambre de prévention de l'oxydation du substrat (302b, 402b) pendant le soudage d'un élément semi-conducteur (112) au substrat, l'élément semi-conducteur comprenant une pluralité de secondes structures électriquement conductrices, la pluralité de premières structures électriquement conductrices étant configurée pour être soudée à celles, correspondantes, de la pluralité de secondes structures électriquement conductrices, **caractérisé en ce qu'**il comprend en outre
une tête de soudage comprenant un outil de soudage (110) destiné à souder l'élément semi-conducteur au substrat, dans lequel
le système d'alimentation en gaz réducteur est intégré à la tête de liaison ; ou
dans lequel le système d'alimentation en gaz réducteur est intégré à la structure de support du substrat.

2. Le système de liaison (300, 400) selon la revendication 1, comprenant en outre un système de transfert de substrat destiné à transférer le substrat (104) de la chambre de réduction de l'oxyde du substrat (302a, 402a) vers la chambre de prévention de l'oxyde du substrat.

3. Le système de liaison (300, 400) selon la revendication 1 ou 2, dans lequel la chambre de prévention de l'oxydation du substrat (302b, 402b) est alimentée en azote afin de créer l'environnement inerte.

4. Le système de liaison (300, 400) selon l'une quelconque des revendications précédentes, comprenant en outre un système de manutention de matériaux destiné à déplacer le substrat (104) à l'intérieur de la chambre de prévention de l'oxydation du substrat (302b, 402b).

5. Le système de liaison (300, 400) selon l'une quelconque des revendications précédentes, dans lequel la chambre de prévention de l'oxydation du substrat (302b, 402b) comprend l'emplacement de liaison (302c, 402c) destiné à recevoir le substrat pendant la liaison de l'élément semi-conducteur au substrat (104).

6. Le système de liaison (300, 400) selon l'une quelconque des revendications précédentes, dans lequel l'élément semi-conducteur est une puce à semi-conducteur.

7. Le système de liaison (300, 400) selon la revendication 6, dans lequel le substrat (104) est une plaquette à semi-conducteurs.

8. Le système de liaison (300, 400) selon l'une quelconque des revendications précédentes, dans lequel au moins une partie de la chambre de réduction de l'oxyde du substrat (302a, 402a) partage une limite commune avec la chambre de prévention de l'oxyde du substrat.

9. Procédé de liaison d'un élément semi-conducteur (112) à un substrat (104), le procédé comprenant les étapes consistant à :
supporter un substrat (104) sur une structure de support de substrat (102) ;
déplacer le substrat (104) dans une chambre de réduction de l'oxyde du substrat (302a, 402a), le substrat comprenant une pluralité de premières structures électriquement conductrices, la chambre de réduction de l'oxyde du substrat étant configurée pour recevoir un gaz réducteur (130) afin qu'il entre en contact avec chacune des premières structures électriquement conductrices de la pluralité ;
déplacer le substrat dans une chambre de prévention de l'oxydation du substrat (302b, 402b) après que le gaz réducteur a été en contact avec la pluralité de premières structures électriquement conductrices, la chambre de prévention de l'oxydation du substrat présentant un environnement inerte (306, 406) lors de la réception du substrat ; et
lier l'élément semi-conducteur (112) au substrat (104) au niveau d'un emplacement de liaison (302c, 402c) à l'aide d'une tête de liaison comprenant un outil de liaison (110) ; et
fournir un environnement de gaz réducteur au niveau de l'emplacement de liaison (302c, 402c) de la chambre de prévention de l'oxydation du substrat (302b, 402b) pendant la liaison de l'élément semi-conducteur (112) au substrat, l'élément semi-conducteur comprenant une pluralité de secondes structures électriquement conductrices, la pluralité de premières structures électriquement conductrices étant configurée pour être liée à celles, correspondantes, de la pluralité de secondes structures électriquement conductrices ; **caractérisé en ce que**
l'environnement de gaz réducteur est fourni par un système d'alimentation en gaz réducteur (308, 408) intégré à
la tête de liaison, ou à
la structure de support du substrat (102).

10. Le procédé selon la revendication 9, comprenant en outre l'étape consistant à transférer le substrat (104) de la chambre de réduction de l'oxyde de substrat (302a, 402a) vers la chambre de prévention de l'oxyde de substrat (302b, 402b) à l'aide d'un système de transfert de substrat.

11. Le procédé selon la revendication 9 ou 10, comprenant en outre l'étape consistant à fournir de l'azote dans la chambre de prévention de l'oxydation du substrat (302b, 402b) afin de créer l'environnement inerte.
